(19) **Europäisches Patentamt / European Patent Office / Office européen des brevets**

(11) **EP 1 697 997 B1**

(12) **FASCICULE DE BREVET EUROPEEN**

(45) Date de publication et mention
de la délivrance du brevet:
**08.07.2015 Bulletin 2015/28**

(21) Numéro de dépôt: **04816449.5**

(22) Date de dépôt: **20.12.2004**

(51) Int Cl.:
*H01L 27/12* *(2006.01)*　　　*G09G 3/32* *(2006.01)*

(86) Numéro de dépôt international:
**PCT/FR2004/003316**

(87) Numéro de publication internationale:
**WO 2005/071755 (04.08.2005 Gazette 2005/31)**

(54) **ECRAN D'AFFICHAGE D'IMAGES ET PROCEDE DE PILOTAGE DE CET ECRAN**

ANZEIGETAFELVORRICHTUNG UND ANZEIGETAFELANSTEUERVERFAHREN

IMAGE DISPLAY SCREEN AND METHOD FOR CONTROLLING SAID SCREEN

(84) Etats contractants désignés:
**DE FR GB**

(30) Priorité: **24.12.2003 FR 0315408**

(43) Date de publication de la demande:
**06.09.2006 Bulletin 2006/36**

(73) Titulaire: **Thomson Licensing
92130 Issy-les-Moulineaux (FR)**

(72) Inventeurs:
• **LE ROY, Philippe
F-35830 BETTON (FR)**
• **PRAT, Christophe
F-44000 NANTES (FR)**

(74) Mandataire: **Arnold, Klaus-Peter
Deutsche Thomson OHG
European Patent Operations
Karl-Wiechert-Allee 74
30625 Hannover (DE)**

(56) Documents cités:
**US-A1- 2002 126 073**

Printed by Jouve, 75001 PARIS (FR)

EP 1 697 997 B1

**Description**

La présente invention concerne un écran d'affichage.

En particulier, l'invention est relative à un écran d'affichage du type à base de matériaux organiques électroluminescents, à matrice active, comprenant des transistors en couches minces.

Ces transistors sont réalisés par cristallisation d'un substrat de Silicium poly-cristallin obtenu par une technique de chauffage d'un substrat de Silicium amorphe par un laser excimère pulsé. Cette technique de fabrication des transistors en couches minces est particulièrement économique.

Cependant, la cristallisation du Silicium amorphe génère la composition de grains de Silicium monocristallin d'orientation différente séparés par des joints de grains. Ces joints de grains introduisent des dispersions de tensions de seuil de déclenchement des transistors et des inhomogénéités de l'intensité du courant les traversant pour une même tension appliquée à leur grille. Or, comme les émetteurs d'un écran produisent une lumière directement proportionnelle au courant qui les traverse, les dispersions des tensions de seuil de déclenchement se traduisent par des variations de luminance de l'écran.

Pour compenser ces dispersions, il est connu notamment par les documents WO 02/071379 et US 6 359 605, des écrans d'affichage du type précité. Toutefois, les transistors de compensation de ces écrans ne sont pas formés dans le prolongement de l'alignement des transistors de modulation d'une colonne. Ce type de formation garantit notamment une tension égale ou du moins proche des tensions de seuil de déclenchement des transistors de modulation et de la tension de seuil de déclenchement du ou des transistors de compensation et par conséquence une meilleure uniformité de la luminance de l'écran.

Il est également connu, notamment par le document EP 1 220 191, d'introduire un transistor de compensation dans chaque circuit d'adressage d'un émetteur de l'écran. Chaque transistor de compensation d'un circuit d'adressage est fabriqué à côté du transistor de modulation de ce même circuit. Ainsi, le transistor de modulation et le transistor de compensation du même circuit d'adressage sont réalisés dans les mêmes conditions, par le même pinceau laser rectiligne de sorte que leurs tensions de seuil de déclenchement ont des valeurs proches aptes à se compenser l'une l'autre.

Toutefois, un tel écran nécessite également la fabrication d'un transistor d'initialisation et d'un transistor de sélection soit un total de quatre transistors pour commander l'émission de chaque émetteur de l'écran. Or, ces transistors réduisent considérablement la surface utile d'émission des pixels. De plus, la fabrication d'un grand nombre de transistors est peu économique.

Le document US 2002/0126073 décrit un dispositif d'affichage électroluminescent à matrice active.

Le document US 2003/0107534 décrit un dispositif électroluminescent conventionnel.

L'invention a pour but de proposer un écran du type précité plus simple à fabriquer et plus économique.

A cet effet, l'invention est définie dans le jeux de revendications 1 à 11.

Selon une caractéristique de l'invention, les moyens de commande ne comprennent aucun moyen autorisant la circulation d'un courant de l'une quelconque des électrodes d'adressage vers les moyens d'alimentation en puissance des émetteurs.

Chaque transistor de modulation associé à un émetteur est susceptible d'être traversé par un courant de drain pour alimenter ledit émetteur, ce courant d'alimentation circulant alors entre deux électrodes d'alimentation qui sont distinctes des électrodes d'adressage. Ainsi, aucun interrupteur de connexion d'une électrode d'adressage à un générateur d'alimentation des émetteurs n'est nécessaire.

De tels interrupteurs sont au contraire présents dans les moyens de commande décrits dans le document WO 02/071379 ou dans le document US6359605. Dans les moyens de commande décrits dans ces documents, les électrodes d'adressages servent à transmettre un courant $I_D$ représentatif d'une donnée d'image aux émetteurs, alors qu'elles servent à transmettre une tension $V_D$ dans le cas de l'invention. Comme la programmation est réalisée en courant (et non en tension comme dans l'invention), les interrupteurs de connexion précédemment cités sont nécessaires pour assurer la circulation du courant de programmation entre chaque électrode d'adressage et le circuit d'alimentation des émetteurs, pendant que la tension de grille du modulateur associé à cet émetteur s'établit progressivement à sa valeur de consigne, par exemple par le système connu de miroir de courant.

Suivant des modes particuliers de réalisation, l'écran d'affichage comporte l'une ou plusieurs des caractéristiques suivantes :

- les moyens de commande comportent au moins un générateur de tension raccordé à l'une ou à chaque électrode d'adressage pour transmettre une tension $V_D$ représentative d'une donnée d'image ;

- le transistor de compensation de chaque colonne d'émetteurs comporte deux électrodes de passage de courant, chaque électrode de passage de courant étant raccordée en série entre l'électrode d'adressage de cette même colonne et les transistors de modulation de cette même colonne ;

- chaque transistor de compensation comprend une électrode de grille et deux électrodes de passage du courant, l'électrode de grille de chaque transistor de compensation étant raccordée à l'électrode de grille de l'ensemble des transistors de modulation de la colonne associée, une électrode de passage du courant de chaque transistor de compensation est raccordée à l'électrode d'adressage de la colonne d'émetteurs associée et l'autre électrode de passage du courant de chaque transistor de compensation est raccordée à son électrode de grille ;

- lesdits transistors de modulation et ledit transistor de compensation associé sont fabriqués sur un substrat de Silicium poly-cristallin obtenu par chauffage d'un substrat de Silicium amorphe, à l'aide d'un pinceau laser, ledit pinceau étant apte à chauffer d'abord une première surface rectangulaire de chauffage du substrat, à se déplacer selon une direction de déplacement et à chauffer ensuite une seconde surface de chauffage rectangulaire, et

- lesdits transistors de modulation associés aux émetteurs d'une même colonne et le transistor de compensation associé sont alignés suivant une unique et même surface de chauffage, la ligne directrice d'alignement s'étendant sensiblement perpendiculairement à la direction du déplacement du pinceau laser ;

- lesdits transistors de modulation et ledit transistor de compensation associé comprennent chacun un canal entre deux couches de matériaux dopés, ledit canal étant connecté à leur électrode de grille, et le canal des transistors de modulation d'une colonne et le canal du transistor de compensation associé ont un axe principal sensiblement parallèle à ladite ligne directrice ;

- les moyens de commande comprennent des moyens d'initialisation des capacités de charge aptes à décharger l'ensemble des capacités de charge raccordées aux transistors de modulation d'une colonne ;

- les moyens d'initialisation comprennent un transistor d'initialisation comprenant une électrode de grille et deux électrodes de passage du courant, une électrode de passage du courant dudit transistor d'initialisation étant connectée à l'électrode de grille des transistors de modulation de ladite colonne, l'électrode de grille dudit transistor d'initialisation étant connectée à une électrode de passage du courant et à l'électrode d'adressage d'une colonne d'émetteur ;

- les moyens d'initialisation comprennent une diode dont la cathode est raccordée à l'électrode de grille des transistors de modulation et dont l'anode est raccordée à l'électrode d'adressage d'une colonne d'émetteurs ;

- les moyens de commande comportent une pluralité de transistors de sélection comportant une électrode de grille et deux électrodes de passage du courant, chaque transistor de sélection ayant une électrode de passage de courant raccordée à un transistor de modulation, une électrode de grille raccordée à une électrode de sélection et une électrode de passage de courant raccordée au transistor de compensation d'une colonne d'émetteurs ;

- les émetteurs sont des diodes électroluminescentes organiques.

L'invention a également pour objet un procédé de pilotage d'un écran d'affichage selon l'une quelconque des revendications 1 à 12, caractérisé en ce que le procédé comporte une étape d'application d'une tension $V_D$ représentative d'une donnée d'image à chaque électrode d'adressage de chaque colonne d'émetteurs.

L'invention sera mieux comprise à la lecture de la description qui va suivre, donnée uniquement à titre d'exemple et faite en se référant aux dessins, sur lesquels :

- la figure 1 est une vue schématique partielle d'un écran selon l'invention ;

- la figure 2 est une vue en perspective représentant un substrat de Silicium chauffé par un rayon laser au cours du processus de fabrication des transistors implantés dans l'écran d'affichage selon l'invention ; et

- les figures 3A à 3E sont des graphes représentant l'évolution au cours du temps de tensions appliquées pendant le procédé d'adressage réalisé par les moyens de commande selon l'invention ; en particulier

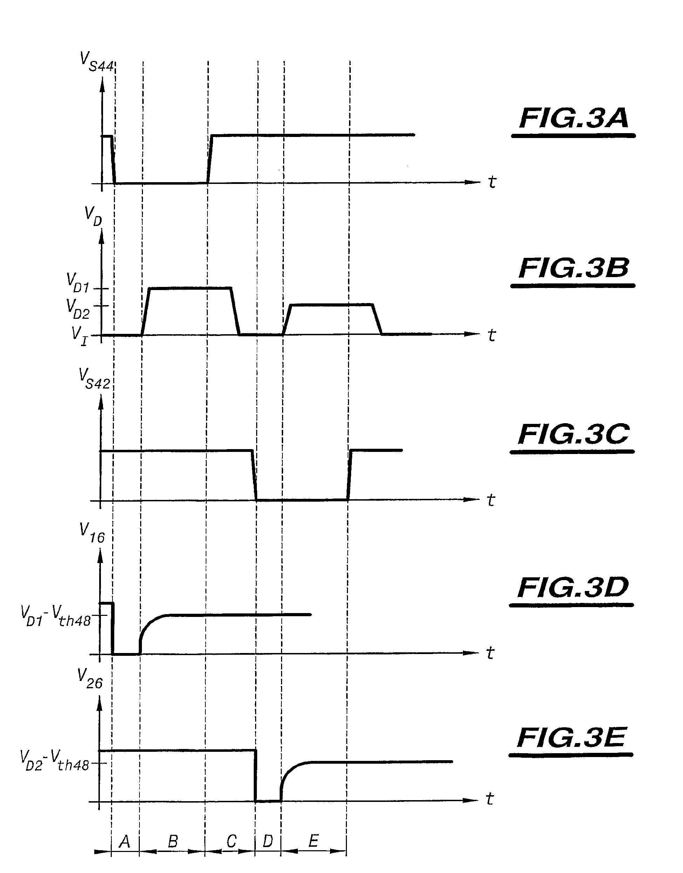

- la figure 3A est un graphe représentant une tension de sélection appliquée à la première électrode de sélection d'un premier circuit d'adressage ;

- la figure 3B est un graphe représentant une tension appliquée à une électrode d'adressage d'une colonne d'émetteurs ;

- la figure 3C est un graphe représentant une tension de sélection appliquée à une seconde électrode de sélection d'un second circuit d'adressage ;

- la figure 3D est un graphe représentant une tension stockée par une capacité de charge d'un premier circuit d'adressage ; et

- la figure 3E est un graphe représentant une tension stockée par une capacité de charge d'un second circuit d'adressage.

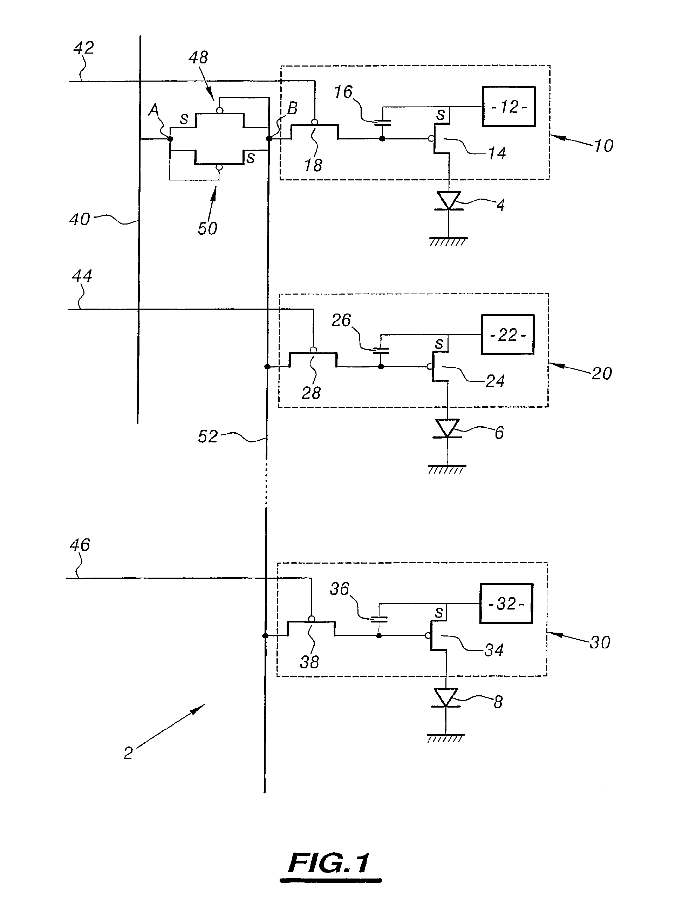

La figure 1 représente partiellement un écran d'affichage selon l'invention. Cet écran comporte des moyens 2 de commande de l'émission de lumière depuis un ensemble d'éléments d'image ou pixels.

L'écran comporte des émetteurs 4, 6, 8 formés de diodes électroluminescentes organiques connues sous l'acronyme OLED dont la luminance est directement proportionnelle au courant qui les traverse. Ils sont répartis selon des lignes d'émetteurs et des colonnes d'émetteurs et forment un réseau.

Les moyens de commande 2 comprennent une pluralité de circuits d'adressage 10, 20, 30 chacun raccordé à un émetteur 4, 6, 8, une électrode d'adressage 40 par colonne d'émetteurs, une électrode de sélection 42, 44, 46 par ligne d'émetteurs, un transistor de compensation 48 et un transistor d'initialisation 50 par colonne d'émetteurs.

Chaque électrode d'adressage 40 est raccordé à un générateur de tension propre à lui appliquer une tension représentative d'une donnée d'image.

Pour des raisons de simplification, seuls trois émetteurs d'une même colonne d'émetteurs ainsi que des moyens de commande 2 d'adressage de ces émetteurs ont été représentés sur la figure 1.

Le premier émetteur 4 de la colonne d'émetteurs est connecté à un premier circuit d'adressage 10. Le deuxième émetteur 6 de la colonne d'émetteurs est connecté à un deuxième circuit d'adressage 20. Enfin, le troisième émetteur 8 de la colonne d'émetteurs est connecté à un troisième circuit d'adressage 30. Les circuits d'adressage 10, 20, 30 de cette colonne sont connectés à une même électrode d'adressage 40, mais sont chacun connecté à une électrode de sélection différente.

Les premier 10, deuxième 20 et troisième 30 circuits d'adressage sont identiques, ils comprennent les mêmes composants électroniques, reliés de la même manière pour réaliser les mêmes fonctions. Pour simplifier la description, seul le premier circuit d'adressage 10 sera décrit de manière détaillée. Toutefois, pour différencier les composants des différents circuits d'adressage, ceux-ci ont une référence composée de la même unité que le premier circuit d'adressage 10 et d'une dizaine différente.

Les circuits d'adressage 10, 20, 30 comprennent un générateur 12, 22, 32 d'alimentation en puissance des émetteurs, un transistor de modulation 14, 24, 34 de courant, une capacité de charge 16, 26, 36 et un interrupteur de sélection 18, 28, 38, formé d'un transistor.

Le transistor de modulation 14, l'interrupteur de sélection 18, le transistor de compensation 48 et le transistor d'initialisation 50 sont des transistors en couches minces de type p. Ils comprennent une électrode de drain, une électrode de source et une électrode de grille. Leur électrode de grille est connectée à un canal de drain formé entre deux couches de matériaux dopés. Ils sont aptes à être traversés par un courant, dit courant de drain, de leur source vers leur drain lorsqu'une tension supérieure ou égale à leur tension de seuil de déclenchement $V_{th}$ est appliquée entre leur grille et leur source. Alternativement, des transistors en couches minces de type n pourraient également être utilisés pour la fabrication d'un écran selon l'invention. Dans ce cas, leur courant de drain circule de leur drain vers leur source.

La source du transistor de modulation 14 est raccordée au générateur 12. Le drain du transistor de modulation 14 est relié à l'anode de l'émetteur 4. La cathode de l'émetteur 4 est branchée à une électrode de masse. La grille du transistor de modulation 14 est raccordée à une borne de la capacité de charge 16 et à l'électrode de drain de l'interrupteur de sélection 18. La seconde borne de la capacité de charge 16 est connectée au générateur 12. La grille des interrupteurs 18, 28 et 38 du premier 10, deuxième 20 et troisième 30 circuits d'adressage est connecté respectivement à la première 42, la deuxième 44 et la troisième 46 électrodes de sélection.

Le transistor de compensation 48 est monté en parallèle au transistor d'initialisation 50 et est raccordé d'une part, au noeud B et d'autre part, à un noeud A d'embranchement avec l'électrode d'adressage 40 de colonne.

L'électrode de source du transistor 48 et l'électrode de drain du transistor 50 sont branchées à l'électrode d'adressage 40 de la colonne d'émetteurs. L'électrode de drain du transistor 48 et l'électrode source du transistor 50 sont connectées entre elles au noeud B.

L'électrode de grille du transistor 48 est reliée à son drain. L'électrode de grille du transistor 50 est également reliée à son drain. En conséquence, le transistor de compensation 48 est équivalent à une diode dont la cathode est connectée au noeud B et dont l'anode est connectée au noeud A. Cette diode est passante quand la différence de potentiel entre le noeud A et le noeud B est supérieure au seuil de déclenchement $V_{th48}$ du transistor 48. Le transistor d'initialisation 50 est lui aussi équivalent à une diode. Cette diode est connectée en inverse par rapport à la diode équivalente au transistor 48. Sa cathode est reliée au noeud A. Son anode est reliée au noeud B. Cette diode est passante quand la différence de potentiel entre le noeud A et le noeud B est inférieure au seuil de déclenchement $V_{th50}$ du transistor 50.

L'électrode de drain du transistor 48 et l'électrode source du transistor 50 sont connectées par une ligne 52 à chaque interrupteur 18, 28, 38 de l'ensemble des circuits d'adressage 10, 20, 30 de la colonne d'émetteurs. La grille du transistor de compensation 48 est connectée à la grille des transistors de modulation 14, 24, 34 de l'ensemble des circuits d'adressage 10, 20, 30 d'une colonne d'émetteurs.

De plus, le transistor de compensation 48 est fabriqué dans les mêmes conditions que l'ensemble des transistors de modulation 14, 24, 34 d'une colonne d'émetteurs de sorte qu'il est apte à compenser les tensions de seuil de déclenchement de l'ensemble des transistors de modulation 14, 24, 34 de cette colonne.

L'électrode d'adressage 40 d'une colonne d'émetteurs est adaptée pour adresser une tension d'adressage représentative d'une donnée d'image aux circuits d'adressage de cette colonne d'émetteurs.

Les électrodes de sélection 42, 44, 46 sont propres à sélectionner un circuit d'adressage défini 10, 20, 30 dans une colonne de circuits d'adressage par application d'une tension de sélection sur une de ces électrodes de sélection de lignes.

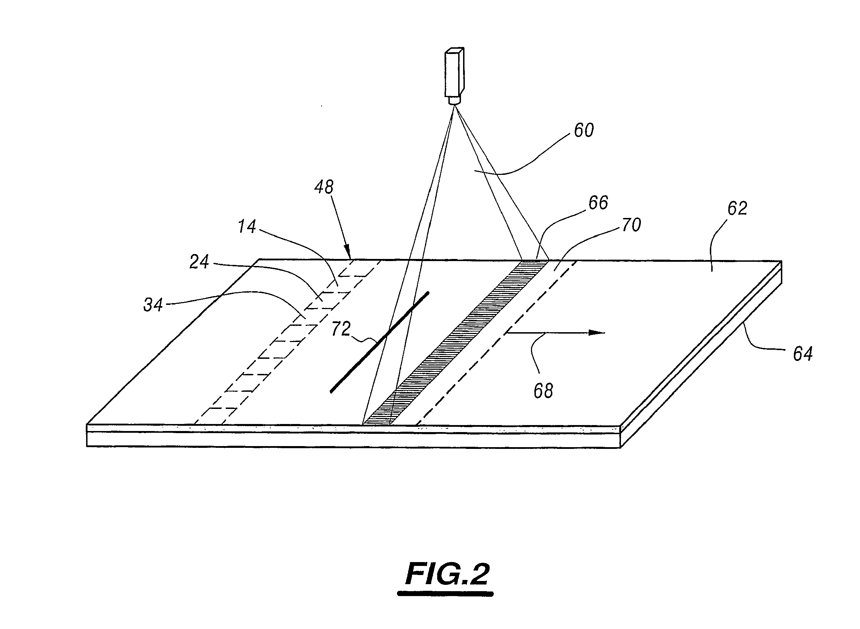

La figure 2 représente schématiquement une étape du procédé de fabrication à basse température du Poly-Silicium formant la structure des transistors utilisés pour générer un écran selon l'invention.

Les transistors de modulation 14, 24 et 34 et de compensation 48 sont formés dans une même couche du Silicium Poly-cristallin obtenue après chauffage et cristallisation d'un substrat de Silicium amorphe.

Pendant l'étape de chauffage du substrat de Silicium amorphe 62, un pinceau laser 60 rectiligne à excimère chauffe une couche mince 62 de Silicium amorphe déposée sur un substrat 64 de verre. Ce pinceau laser 60 puisé chauffe d'abord une première surface rectangulaire 66 qui s'étend longitudinalement le long d'une ligne directrice 72 puis, se déplace selon une direction de déplacement 68 et chauffe ensuite une seconde surface de chauffage 70 adjacente à la première surface de chauffage 66 et de même forme que celle-ci.

Les transistors de modulation d'une colonne d'émetteurs ainsi que le transistor de compensation 48 apte à compenser la tension de seuil de déclenchement de l'ensemble des transistors de modulation de cette colonne ont été représentés schématiquement en pointillés sur la figure 2.

Les transistors de modulation 14, 24, 34 d'une colonne adressés par la même électrode d'adressage 40 ainsi que le transistor de compensation 48 auquel ils sont reliés sont formés de manière à être positionnés alignés les uns dans le prolongement des autres, parallèlement à la grande longueur des surfaces de chauffage 66, 70 et perpendiculairement au sens de déplacement 68 du pinceau laser 60: De plus, ces transistors sont fabriqués sur une unique et même surface de chauffage 66 chauffée simultanément par le même pinceau laser 60. Plus précisément, les transistors de modulation 14, 24 et 34 et de compensation 48 sont réalisés de manière à ce que leur canal de drain ait un axe principal sensiblement perpendiculaire à la direction 68 de déplacement du pinceau laser.

En conséquence, ils présentent des tensions de seuil de déclenchement ayant des valeurs proches de sorte que le transistor de compensation 48 est apte à compenser les tensions de seuil de déclenchement de l'ensemble des transistors de modulation 14, 24, 34 d'une colonne d'émetteurs.

Les figures 3A à 3E représentent les étapes d'adressage des émetteurs d'un écran d'affichage selon l'invention.

Au cours d'une étape A d'initialisation du transistor de modulation 14, une tension de sélection $V_{S42}$ est appliquée à l'électrode 42. L'interrupteur 18 est débloqué. Une tension d'adressage $V_D$, de valeur nulle ci-après nommée tension d'initialisation $V_I$, est appliquée à l'électrode d'adressage 40. La tension au noeud A est inférieure à la tension au noeud B. Le transistor d'initialisation 50 est débloqué, tandis que le transistor de compensation 48 se bloque. La tension d'initialisation est alors appliquée à la grille du modulateur 14 et à une borne de la capacité de charge 16 qui se décharge, tel qu'illustré sur la figure 3D.

Au cours d'une étape B de programmation de la capacité de charge 16, une tension d'adressage $V_{D1}$ représentative d'une donnée d'image, est appliquée à l'électrode d'adressage 40, cette tension est modulée par le transistor de compensation 48 et est transmise au noeud B. Au noeud B, la valeur de la tension modulée par le transistor 48 est égale à $V_{D1} - V_{th48}$ où $V_{th48}$ est la tension de seuil de déclenchement du transistor 48.

La tension de sélection $V_{S42}$ est toujours appliquée à la grille de l'interrupteur de sélection 18, l'interrupteur 18 est débloqué. La tension d'adressage $V_{D1}$ modulée par le transistor de compensation 48, est appliquée à la grille du transistor de modulation 14 et à une borne de la capacité de charge 16. Après un instant, le transistor de modulation 14 fonctionne en régime de saturation et son courant de drain $I_d$ est défini par l'équation suivante :

$$I_d = \beta \times \left(V_{gs14} - V_{th14}\right)^2$$

avec $V_{gs14} = V_{12} - V_{16}$
et $V_{16} = V_{D1} - V_{th48}$
Où $I_d$ représente le courant de drain traversant le transistor de modulation 14,
$\beta$ représente une constante fonction de la technologie employée et des caractéristiques du canal des transistors,
$V_{gs14}$ représente la tension entre la grille et la source du transistor de modulation 14,
$V_{12}$ représente la tension d'alimentation du générateur 12,
$V_{16}$ représente la tension aux bornes de la capacité de charge 16,
$V_{D1}$ représente la tension d'adressage de donnée,
$V_{th48}$ représente la tension de seuil de déclenchement du transistor de compensation 48.

Comme les transistors de modulation 14 et de compensation 48 ont été fabriqués sur la même surface de chauffage, ils ont des tensions de seuil de déclenchement similaires.

$$V_{th48} = V_{th14}$$

alors

$$I_d = \beta \times \left(V_{12} - V_{D1}\right)^2$$

Ainsi, le courant de drain $I_d$ traversant le transistor de modulation 14 est indépendant de sa tension de seuil de déclenchement $V_{th14}$. La tension de seuil de déclenchement $V_{th48}$ du transistor de compensation 48 compense la tension de seuil de déclenchement du transistor de modulation $V_{th14}$ de sorte que la luminance du pixel associé à l'émetteur 2 est constante pour une tension d'adressage donnée.

Au cours d'une étape intermédiaire C, une tension de sélection $V_{S44}$ est appliquée à la deuxième électrode de sélection 44. L'interrupteur 28 du second circuit d'adressage 20 est débloqué. A la fin de l'étape C, la tension de sélection $V_{S42}$ cesse d'être appliquée à l'électrode de sélection 42 du premier circuit d'adressage 10 de sorte que l'interrupteur 18 est bloqué. La capacité de charge 16 stocke des charges à la grille du transistor de modulation 14 de sorte que celui-ci continue à alimenter l'émetteur 4 jusqu'à la prochaine étape d'initialisation $V_I$ du modulateur 14, tel qu'illustré sur la figure 3D.

Au cours d'une étape D d'initialisation de la capacité de charge 26 du second circuit d'adressage 20, une tension d'adressage $V_D$ de valeur nulle dite tension d'initialisation $V_I$ est appliquée à l'électrode d'adressage 40 de colonne. Par suite, la tension au noeud A devient inférieure à la tension au noeud B. Le transistor d'initialisation 50 devient passant et le transistor de compensation 48 se bloque. La tension d'initialisation adressée par l'électrode d'adressage 40, modulée par le transistor 50, est alors transférée aux bornes de la capacité de charge 26 qui se décharge.

Au cours d'une étape E de programmation de la capacité de charge 26, une tension d'adressage $V_{D2}$ est appliquée à l'électrode d'adressage 40. La tension au noeud A devient supérieure à la tension au noeud B. Le transistor de compensation 48 est à nouveau débloqué tandis que le transistor d'initialisation 50 se bloque. La tension au noeud B, modulée par le transistor de compensation 48 est égale à $V_{D2} - V_{th48}$ où $V_{th48}$ représente la tension de seuil de déclenchement du transistor de compensation 48. La tension au noeud B est transmise à la grille du modulateur 24 par la ligne 52 et l'interrupteur 28 qui a été débloqué par application d'une tension de sélection $V_{S44}$ sur l'électrode de sélection 44.

Comme les transistors de modulation 24 et de compensation 48 ont été fabriqués sur la même surface de chauffage le long de la même ligne directrice 72, la tension de seuil $V_{th48}$ du transistor 48 est identique à la tension de seuil $V_{th24}$ du transistor 24.

$$V_{th48} = V_{th24}$$

En conséquence,

$$I_d = \beta \times \left( V_{22} - V_{D2} \right)^2$$

Où $V_{22}$ représente la tension d'alimentation du générateur 22,

$V_{D2}$ représente la tension d'adressage de donnée.

Ainsi, le transistor de compensation 48 est apte à compenser la tension de seuil de déclenchement du transistor de modulation 14 du premier circuit d'adressage 10, du transistor de modulation 24 du deuxième circuit d'adressage 20 et de l'ensemble des transistors de modulation d'une même colonne quand ses transistors sont obtenus par chauffage simultanément d'une surface de Silicium et disposés le long d'une même ligne.

De plus, le transistor d'initialisation 50 des capacités de charge est apte à décharger l'ensemble des capacités de charge 16, 26, 36 des circuits d'adressage d'une même colonne.

Alternativement, le transistor d'initialisation 50 peut être remplacé par une diode dont la cathode est raccordée à l'électrode de grille des transistors de modulation et dont l'anode est raccordée à l'électrode d'adressage de colonne d'émetteurs associée à ladite colonne de transistors.

Avantageusement, les circuits d'adressage de l'écran selon l'invention sont pilotés en tension de sorte que l'adressage des pixels est réalisé plus rapidement. En effet, les temps de programmation en courant ne sont plus nécessaires puisque la tension est directement appliquée à la grille des modulateurs et aux capacités de charge. De plus, les circuits d'adressage pilotés en tension sont simples à réaliser et ont un coût de fabrication avantageux par rapport aux circuits d'adressage en courant.

## Revendications

1. Ecran d'affichage comportant :

   - des émetteurs de lumière (4, 6, 8) répartis selon des lignes d'émetteurs et des colonnes d'émetteurs pour former un réseau d'émetteurs,
   - un substrat de Silicium poly-cristallin (62), obtenu à partir d'un substrat de Silicium amorphe selon un procédé de fabrication à basse température utilisant un pinceau laser, sur lequel des moyens de commande (2, 10, 20, 30, 40, 42, 44, 46, 48, 50) de l'émission des émetteurs sont fabriqués, lesdits moyens de commande comprenant :

     - des moyens (12, 22, 32) d'alimentation en puissance des émetteurs de lumière (4, 6, 8),
     - une pluralité d'électrodes d'adressage (40) réparties selon les colonnes d'émetteurs, et aptes à transmettre une tension ($V_D$) représentative d'une donnée d'image à chaque colonne d'émetteurs,
     - au moins un générateur de tension raccordé à l'une ou à chaque électrode d'adressage (40) pour transmettre une tension ($V_D$) représentative d'une donnée d'image,
     - une pluralité d'électrodes de sélection (42, 44, 46) réparties selon les lignes d'émetteurs, et aptes à transmettre un signal de sélection ($V_{S42}$, $V_{S44}$) à chaque ligne d'émetteurs,
     - une pluralité de transistors de modulation (14, 24, 34), chacun associé à un émetteur du réseau, lesdits transistors de modulation comprenant une électrode de grille apte à être reliée à une électrode d'adressage (40) et deux électrodes de passage du courant, chaque transistor de modulation étant apte à être traversé par un courant de drain pour alimenter ledit émetteur pour une tension entre son électrode de grille et une de ses électrodes de passage de courant supérieure ou égale à une tension de seuil de déclenchement ($V_{th}$), lesdits transistors de modulation étant répartis selon des colonnes associées aux colonnes d'émetteurs et étant alignés sur le substrat (62) suivant une ligne directrice (72),

- une capacité de charge (16, 26, 36) connectée aux bornes de chaque transistor de modulation (14, 24, 34) et apte à imposer un potentiel électrique à l'électrode de grille du transistor de modulation associé, et
- une pluralité de transistors de compensation (48) aptes à compenser la tension de seuil de déclenchement des transistors de modulation en ajustant la charge du condensateur, chaque transistor de compensation (48) comprenant une électrode de grille et deux électrodes de passage du courant, l'électrode de grille de chaque transistor de compensation (48) étant raccordée à l'électrode de grille de l'ensemble des transistors de modulation (14, 24, 34) de la colonne associée, une électrode (51) de passage du courant de chaque transistor de compensation (48) étant raccordée à l'électrode d'adressage (40) de la colonne d'émetteurs associée, et l'autre électrode de passage du courant de chaque transistor de compensation étant raccordée à son électrode de grille, un unique transistor de compensation (48) étant connecté à l'ensemble des transistors de modulation (14, 24, 34) d'une même colonne et étant apte à compenser les tensions de seuil de déclenchement de l'ensemble desdits transistors de modulation (14, 24, 34) de cette colonne, **caractérisé en ce que** ledit transistor de compensation (48) est formé dans le prolongement de l'alignement desdits transistors de modulation (14, 24, 34) d'une même colonne suivant ladite même ligne directrice (72), sur une unique et même surface, la dite surface étant chauffée simultanément par le dit pinceau laser lors de la fabrication.

2. Ecran d'affichage selon la revendication 1, **caractérisé en ce que** les moyens de commande ne comprennent aucun moyen autorisant la circulation d'un courant de l'une quelconque des électrodes d'adressage (40) vers les moyens (12, 22, 32) d'alimentation en puissance des émetteurs.

3. Ecran d'affichage selon la revendication 1 ou 2, **caractérisé en ce que** le transistor de compensation (48) de chaque colonne d'émetteurs comporte deux électrodes de passage de courant, chaque électrode de passage de courant étant raccordée en série entre l'électrode d'adressage (40) de cette même colonne et les transistors de modulation (14, 24, 34) de cette même colonne.

4. Ecran d'affichage selon l'une quelconque des revendications 1 à 3, **caractérisé en ce que** lesdits transistors de modulation (14, 24, 34) et ledit transistor de compensation (48) associé sont fabriqués sur un substrat de Silicium poly-cristallin obtenu par chauffage d'un substrat (62) de Silicium amorphe, à l'aide d'un pinceau laser (60), ledit pinceau étant apte à chauffer d'abord une première surface (66) rectangulaire de chauffage du substrat, à se déplacer selon une direction de déplacement (68) et à chauffer ensuite une seconde surface (70) de chauffage rectangulaire, et **en ce que** lesdits transistors de modulation (14, 24, 34) associés aux émetteurs d'une même colonne et le transistor de compensation associé sont alignés suivant une unique et même surface de chauffage (66), la ligne directrice (72) d'alignement s'étendant sensiblement perpendiculairement à la direction du déplacement (68) du pinceau laser (60).

5. Ecran d'affichage selon l'une quelconque des revendications précédentes, **caractérisé en ce que** lesdits transistors de modulation (14, 24, 34) et ledit transistor de compensation (48) associé comprennent chacun un canal entre deux couches de matériaux dopés, ledit canal étant connecté à leur électrode de grille, et **en ce que** le canal des transistors de modulation (14, 24, 34) d'une colonne et le canal du transistor de compensation associé ont un axe principal sensiblement parallèle à ladite ligne directrice (72).

6. Ecran d'affichage selon l'une quelconque des revendications précédentes, **caractérisé en ce que** les moyens de commande (2, 10, 20, 30, 40, 42, 44, 46, 48, 50) comprennent des moyens d'initialisation (50) des capacités de charge (16, 26, 36) aptes à décharger l'ensemble des capacités de charge raccordées aux transistors de modulation d'une colonne.

7. Ecran d'affichage selon la revendication 6, **caractérisé en ce que** les moyens d'initialisation (50) comprennent un transistor d'initialisation (50) comprenant une électrode de grille et deux électrodes de passage du courant, une électrode de passage du courant dudit transistor d'initialisation (50) étant connectée à l'électrode de grille des transistors de modulation (14, 24, 34) de ladite colonne, l'électrode de grille dudit transistor d'initialisation (50) étant connectée à une électrode de passage du courant et à l'électrode d'adressage (40) d'une colonne d'émetteurs.

8. Ecran d'affichage selon la revendication 6, **caractérisé en ce que** les moyens d'initialisation (50) comprennent une diode dont la cathode est raccordée à l'électrode de grille des transistors de modulation (14, 24, 34) et dont l'anode est raccordée à l'électrode d'adressage (40) d'une colonne d'émetteurs.

9. Ecran d'affichage selon l'une quelconque des revendications précédentes, **caractérisé en ce que** les moyens de commande (2, 10, 20, 30, 40, 42, 44, 46, 48, 50) comportent une pluralité de transistors de sélection (18, 28, 38) comportant une électrode de grille et deux électrodes de passage du courant, chaque transistor de sélection ayant une électrode de passage de courant raccordée à un transistor de modulation (14, 24, 34), une électrode de grille raccordée à une électrode de sélection (42, 44, 46) et une électrode de passage de courant raccordée au transistor de compensation (48) d'une colonne d'émetteurs.

10. Ecran d'affichage selon l'une quelconque des revendications précédentes, **caractérisé en ce que** les émetteurs (4) sont des diodes électroluminescentes organiques.

11. Procédé de pilotage d'un écran d'affichage selon l'une quelconque des revendications 1 à 10, **caractérisé en ce que** le procédé comporte une étape d'application d'une tension ($V_D$) représentative d'une donnée d'image à chaque électrode d'adressage (40) de chaque colonne d'émetteurs (4, 6, 8).

**Patentansprüche**

1. Anzeigebildschirm, umfassend:

   - Lichtemitter (4, 6, 8), die entsprechend Emitterleitungen und Emitterspalten verteilt sind, um ein Emitternetz zu bilden,
   - ein polykristallines Siliziumsubstrat (62), das ausgehend von einem amorphen Siliziumsubstrat nach einem Herstellungsverfahren bei niedriger Temperatur unter Verwendung eines Laserbündels erhalten wurde, auf welchem Steuerungsmittel (2, 10, 20, 30, 40, 42, 44, 46, 48, 50) der Emission der Emitter hergestellt sind, wobei die besagten Steuerungsmittel Folgendes umfassen:

      - Mittel (12, 22, 32) zur Leistungsversorgung der Lichtemitter (4, 6, 8),
      - eine Mehrzahl an Adressierelektroden (40), die entsprechend den Emitterspalten verteilt sind, und dazu geeignet, eine Spannung ($V_D$), die repräsentativ für einzelne Bilddaten ist, an jede Emitterspalte zu übertragen,
      - mindestens ein Spannungsgenerator, der an eine oder an jede Adressierelektrode (40) angeschlossen ist, um eine Spannung ($V_D$), die repräsentativ für einzelne Bilddaten ist, zu übertragen,
      - eine Mehrzahl an Auswahlelektroden (42, 44, 46), die entsprechend den Emitterleitungen verteilt sind, und dazu geeignet, ein Auswahlsignal ($V_{S42}$, $V_{S44}$) an jede Emitterleitung zu übertragen,
      - eine Mehrzahl an Modulationstransistoren (14, 24, 34), von denen jeder mit einem Emitter des Netzes verbunden ist, wobei die besagten Modulationstransistoren eine Gate-Elektrode enthalten, die geeignet ist, um mit einer Adressierelektrode (40) verbunden zu werden, und zwei Elektroden zum Durchleiten des Stroms, wobei jeder Modulationstransistor dazu geeignet ist, von einem Drain-Strom durchflossen zu werden, um den besagten Emitter zu versorgen, für eine Spannung zwischen seiner Gate-Elektrode und einer seiner Elektroden zum Durchleiten des Stroms, die höher oder gleich einer Auslöseschwellenspannung ($V_{th}$) ist, wobei die besagten Modulationstransistoren entsprechend den mit den Emitterspalten verbundenen Spalten verteilt sind und auf dem Substrat (62) entsprechend einer Führungslinie (72) in einer Reihe angeordnet sind,
      - eine Ladekapazität (16, 26, 36), die an die Klemmen jedes Modulationstransistors (14, 24, 34) angeschlossen ist, und geeignet, um die Gate-Elektrode des verbundenen Modulationstransistors einem elektrischen Potential auszusetzen, und
      - eine Mehrzahl von Kompensationstransistoren (48), geeignet, um die Auslöseschwellenspannung der Modulationstransistoren zu kompensieren, indem die Ladung des Kondensators angepasst wird, wobei jeder Kompensationstransistor (48) eine Gate-Elektrode und zwei Elektroden zum Durchleiten des Stroms umfasst, wobei die Gate-Elektrode von jedem Kompensationstransistor (48) an die Gate-Elektrode der Gesamtheit der Modulationstransistoren (14, 24, 34) der verbundenen Spalte angeschlossen ist, wobei eine Elektrode (51) zum Durchleiten des Stroms von jedem Kompensationstransistor (48) an die Adressierelektrode (40) der verbundenen Emitterspalte angeschlossen ist, und die andere Elektrode zum Durchleiten des Stroms jedes Kompensationstransistors an seine Gate-Elektrode angeschlossen ist, wobei ein einziger Kompensationstransistor (48) mit der Gesamtheit der Modulationstransistoren (14, 24, 34) ein- und derselben Spalte verbunden ist und geeignet ist, um die Auslöseschwellenspannungen der Gesamtheit der besagten Modulationstransistoren (14, 24, 34) dieser Spalte zu kompensieren, **dadurch gekennzeichnet, dass** der besagte Kompensationstransistor (48) in der Verlängerung der Aneinanderreihung der besagten Modulationstransistoren (14, 24, 34) ein- und derselben Spalte gemäß derselben besagten Führungslinie (72) ausgebildet ist, auf einer einzigen und selben Oberfläche, wobei die besagte Oberfläche gleichzeitig durch das besagte Laserbündel während der Erzeugung erwärmt wird.

**2.** Anzeigebildschirm nach Anspruch 1, **dadurch gekennzeichnet, dass** die Steuerungsmittel kein Mittel umfassen, das die Zirkulation von Strom von irgendeiner der Adressierelektroden (40) hin zu den Mitteln (12, 22, 32) zur Leistungsversorgung der Emitter gestattet.

**3.** Anzeigebildschirm nach Anspruch 1 oder 2, **dadurch gekennzeichnet, dass** der Kompensationstransistor (48) von jeder Emitterspalte zwei Elektroden zum Durchleiten von Strom umfasst, wobei jede Elektrode zum Durchleiten von Strom zwischen der Adressierelektrode (40) von ebendieser Spalte und den Modulationstransistoren (14, 24, 34) von ebendieser Spalte in Reihe angeschlossen ist.

**4.** Anzeigebildschirm nach einem der Ansprüche 1 bis 3, **dadurch gekennzeichnet, dass** die besagten Modulationstransistoren (14, 24, 34) und der besagte verbundene Kompensationstransistor (48) auf einem polykristallinen Siliziumsubstrat hergestellt sind, das durch Erhitzen eines Substrats (62) vom amorphen Silizium mit Hilfe eines Laserbündels (60) erhalten wird, wobei das besagte Bündel dazu geeignet ist, zunächst eine erste rechteckige Heizfläche (66) des Substrats zu erhitzen, sich entsprechend einer Bewegungsrichtung (68) zu bewegen und anschließend eine zweite rechteckige Heizfläche (70) zu erhitzen, und dadurch, dass die besagten Modulationstransistoren (14, 24, 34), die mit den Emittern ein- und derselben Spalte verbunden sind, und der verbundene Kompensationstransistor gemäß einer einzigen und selben Heizfläche (66) in einer Reihe angeordnet sind, wobei sich die Ausrichtungsführungslinie (72) im Wesentlichen senkrecht zur Bewegungsrichtung (68) des Laserbündels (60) erstreckt.

**5.** Anzeigebildschirm nach einem der vorstehenden Ansprüche, **dadurch gekennzeichnet, dass** die besagten Modulationstransistoren (14, 24, 34) und der besagte verbundene Kompensationstransistor (48) jeder einen Kanal zwischen zwei Schichten aus dotierten Materialien umfassen, wobei der besagte Kanal an ihre Gate-Elektrode angeschlossen ist, und dadurch, dass der Kanal der Modulationstransistoren (14, 24, 34) einer Spalte und der Kanal des verbundenen Kompensationstransistors eine Hauptachse haben, die im Wesentlichen parallel zu der besagten Führungslinie (72) verläuft.

**6.** Anzeigebildschirm nach einem der vorstehenden Ansprüche, **dadurch gekennzeichnet, dass** die Steuerungsmittel (2, 10, 20, 30, 40, 42, 44, 46, 48, 50) Mittel zur Initialisierung (50) der Ladekapazitäten (16, 26, 36) umfassen, dazu geeignet, die Gesamtheit der an die Modulationstransistoren einer Spalte angeschlossenen Ladekapazitäten zu entladen.

**7.** Anzeigebildschirm nach Anspruch 6, **dadurch gekennzeichnet, dass** die Initialisierungsmittel (50) einen Initialisierungstransistor (50) umfassen, der eine Gate-Elektrode und zwei Elektroden zum Durchleiten des Stroms enthält, wobei eine Elektrode zum Durchleiten des Stroms des besagten Initialisierungstransistors (50) an die Gate-Elektrode der Modulationstransistoren (14, 24, 34) der besagten Spalte angeschlossen ist, wobei die Gate-Elektrode des besagten Initialisierungstransistors (50) an eine Elektrode zum Durchleiten des Stroms und an die Adressierelektrode (40) einer Emitterspalte angeschlossen ist.

**8.** Anzeigebildschirm nach Anspruch 6, **dadurch gekennzeichnet, dass** die Initialisierungsmittel (50) eine Diode umfassen, deren Kathode an die Gate-Elektrode der Modulationstransistoren (14, 24, 34) angeschlossen ist und deren Anode an die Adressierelektrode (40) einer Emitterspalte angeschlossen ist.

**9.** Anzeigebildschirm nach einem der vorstehenden Ansprüche, **dadurch gekennzeichnet, dass** die Steuerungsmittel (2, 10, 20, 30, 40, 42, 44, 46, 48, 50) eine Mehrzahl an Auswahltransistoren (18, 28, 38) umfassen, die eine Gate-Elektrode und zwei Elektroden zum Durchleiten des Stroms umfassen, wobei jeder Auswahltransistor verfügt über: eine Elektrode zum Durchleiten von Strom, die an einen Modulationstransistor (14, 24, 34) angeschlossen ist, eine Gate-Elektrode, die an eine Auswahlelektrode (42, 44, 46) angeschlossen ist, und eine Elektrode zum Durchleiten von Strom, die an den Kompensationstransistor (48) einer Emitterspalte angeschlossen ist.

**10.** Anzeigebildschirm nach einem der vorstehenden Ansprüche, **dadurch gekennzeichnet, dass** die Emitter (4) organische Leuchtdioden sind.

**11.** Ansteuerungsverfahren eines Anzeigebildschirms nach einem der Ansprüche 1 bis 10, **dadurch gekennzeichnet, dass** das Verfahren einen Schritt zur Anwendung einer für einzelne Bilddaten repräsentativen Spannung ($V_D$) auf jede Adressierelektrode (40) von jeder Emitterspalte (4, 6, 8) umfasst.

## Claims

**1.** Display screen comprising:

- light emitters (4, 6, 8) arranged in rows of emitters and columns of emitters to form an array of emitters,
- a polycrystalline silicon substrate (62), obtained from an amorphous silicon substrate according to a low-temperature manufacturing method using a laser beam, on which control means (2, 10, 20, 30, 40, 42, 44, 46, 48, 50) for controlling the emission of the emitters are manufactured, said control means comprising:

- means (12, 22, 32) for powering the light emitters (4, 6, 8),
- a plurality of addressing electrodes (40) arranged according to the columns of emitters, and able to transmit a voltage ($V_D$) representative of an item of image data to each column of emitters,
- at least one voltage generator connected to one or to each addressing electrode (40) in order to transmit a voltage ($V_D$) 15 representative of an item of image data,
- a plurality of selection electrodes (42, 44, 46) arranged according to the rows of emitters, and able to transmit a selection signal ($V_{S42}$, $V_{S44}$) to each row of emitters,
- a plurality of modulation transistors (14, 24, 34), each associated with an emitter of the array, said modulation transistors comprising a gate electrode able to be connected to an addressing electrode (40) and two current-carrying electrodes, each modulation transistor being able to have a drain current pass through it to power said emitter for a voltage between its gate electrode and one of its current-carrying electrodes that is greater than or equal to a threshold trigger voltage ($V_{th}$), said modulation transistors being arranged in columns associated with the columns of emitters and being aligned on the substrate (62) along a guiding line (72),
- a load capacitor (16, 26, 36) connected to the terminals of each modulation transistor (14, 24, 34) and able to set an electric potential at the gate electrode of the associated modulation transistor, and
- a plurality of compensating transistors (48) able to compensate for the threshold trigger voltage of the modulation transistors by adjusting the charge on the capacitor, each compensating transistor (48) comprising a gate electrode and two current-carrying electrodes, the gate electrode of each compensating transistor (48) being connected to the gate electrode of all the modulation transistors (14, 24, 34) of the associated column, one current-carrying electrode (51) of each compensating transistor (48) being connected to the addressing electrode (40) of the associated column of emitters, and the other current-carrying electrode of each compensating transistor being connected to its gate electrode, a single compensating transistor (48) being connected to all the modulation transistors (14, 24, 34) of a same column and being able to compensate for the threshold trigger voltages of all said modulation transistors (14, 24, 34) of this column,

**characterised in that** said compensating transistor (48) is formed in the extension of the line-arrangement of said modulation transistors (14, 24, 34) of a same column along said same guiding line (72), on a single and same surface, said surface being heated simultaneously by said laser beam during manufacture.

**2.** Display screen according to claim 1, **characterised in that** the control means do not comprise any means allowing the flow of current from any one of the addressing electrodes (40) to the means (12, 22, 32) for powering the emitters.

**3.** Display screen according to claim 1 or 2, **characterised in that** the compensating transistor (48) of each column of emitters comprises two current-carrying electrodes, each current-carrying electrode being connected in series between the addressing electrode (40) of this same column and the modulation transistors (14, 24, 34) of this same column.

**4.** Display screen according to any one of claims 1 to 3, **characterised in that** said modulation transistors (14, 24, 34) and said associated compensating transistor (48) are manufactured on a polycrystalline silicon substrate obtained by heating an amorphous silicon substrate (62), using a laser beam (60), said beam being able first to heat a first rectangular heating surface (66) of the substrate, to move in a direction of movement (68) and then to heat a second rectangular heating surface (70), and **in that** said modulation transistors (14, 24, 34) associated with the emitters of a same column and the associated compensating transistor are aligned in a single and same heating surface (66), the guiding alignment line (72) extending substantially perpendicularly to the direction of movement (68) of the laser beam (60).

5. Display screen according to any one of the preceding claims, **characterised in that** said modulation transistors (14, 24, 34) and said associated compensating transistor (48) each comprise a channel between two layers of doped material, said channel being connected to their gate electrode, and **in that** the channel of the modulation transistors (14, 24, 34) of a column and the channel of the associated compensating transistor have a main axis substantially parallel to said guiding line (72).

6. Display screen according to any one of the preceding claims, **characterised in that** the control means (2, 10, 20, 30, 40, 42, 44, 46, 48, 50) comprise initialisation means (50) for initialising the load capacitors (16, 26, 36) able to discharge all the load capacitors connected to the modulation transistors of a column.

7. Display screen according to claim 6, **characterised in that** the initialisation means (50) comprise an initialisation transistor (50) comprising a gate electrode and two current-carrying electrodes, one current-carrying electrode of said initialisation transistor (50) being connected to the gate electrode of the modulation transistors (14, 24, 34) of said column, the gate electrode of said initialisation transistor (50) being connected to a current-carrying electrode and to the addressing electrode (40) of a column of emitters.

8. Display screen according to claim 6, **characterised in that** the initialisation means (50) comprise a diode, the cathode of which is connected to the gate electrode of the modulation transistors (14, 24, 34) and the anode of which is connected to the addressing electrode (40) of a column of emitters.

9. Display screen according to any one of the preceding claims, **characterised in that** the control means (2, 10, 20, 30, 40, 42, 44, 46, 48, 50) comprise a plurality of selection transistors (18, 28, 38) comprising a gate electrode and two current-carrying electrodes, each selection transistor having one current-carrying electrode connected to a modulation transistor (14, 24, 34), a gate electrode connected to a selection electrode (42, 44, 46) and one current-carrying electrode connected to the compensating transistor (48) of a column of light emitters.

10. Display screen according to any one of the preceding claims, **characterised in that** the emitters (4) are organic light-emitting diodes.

11. Method for driving a display screen according to any one of claims 1 to 10, **characterised in that** the method comprises a step of applying a voltage (VD) representative of an item of image data to each addressing electrode (40) of each column of emitters (4, 6, 8).

**FIG.1**

_**FIG.2**_

EP 1 697 997 B1

*FIG.3A*

*FIG.3B*

*FIG.3C*

*FIG.3D*

*FIG.3E*

## RÉFÉRENCES CITÉES DANS LA DESCRIPTION

**Documents brevets cités dans la description**

- WO 02071379 A
- US 6359605 B
- EP 1220191 A
- US 20020126073 A
- US 20030107534 A